# EUROPEAN PATENT APPLICATION

(11) **EP 2 657 718 A1**
(43) Date of publication of application: **30.10.2013**
(21) Application number: 12165755.5
(22) Date of filing: 26.04.2012
(51) Int. Cl.: G01R 33/563

(54) **MRI with arterial spin labeling in combination with a navigator sequence**

(71) Applicant: Koninklijke Philips N.V., 5656 AE Eindhoven (NL); Philips Intellectual Property & Standards GmbH, 20099 Hamburg (DE)
(72) Inventor: Helle, Michael, 5600 AE Eindhoven (NL); Boernert, Peter, 5600 AE Eindhoven (NL)
(74) Representative: Damen, Daniel Martijn

(57) **Abstract**

The invention relates to a method of MR imaging of at least a portion of a body (10) placed in a main magnetic field within the examination volume of a MR device. It is an object of the invention to enable MR imaging using arterial spin labeling (ASL) with reliable motion detection and motion compensation. The method of the invention comprises the following steps:
- subjecting the portion of the body (10) to a spatially selective preparation sequence comprising one or more RF pulses and switched magnetic field gradients, which preparation sequence excites nuclear magnetization outside or inside an imaging region;
- subjecting the portion of the body (10) to a spatially selective acquisition sequence comprising one or more RF pulses and switched magnetic field gradients, whereby MR signals are acquired from the imaging region;
- subjecting the portion of the body (10) to a navigator sequence comprising one or more RF pulses and switched magnetic field gradients, which navigator sequence is applied at least once before, during or after the preparation sequence and/or before, during or after the acquisition sequence, whereby navigator signals are acquired from the portion of the body (10);
- deriving translation and/or rotation data from the navigator signals, which translation and/or rotation data reflect motion of the body (10);
- reconstructing a MR image from the acquired MR signals,
wherein the translation and/or rotation data are used for adapting the preparation sequence and/or the imaging sequence and/or for motion correction during reconstruction of the MR image.

## Description

### FIELD OF THE INVENTION

The present invention relates to the field of magnetic resonance (MR). It finds particular application in conjunction with MR imaging methods and MR devices for diagnostic purposes, and will be described with particular reference thereto.

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

### BACKGROUND OF THE INVENTION

According to the MR method in general, the body of the patient to be examined is arranged in a strong, uniform magnetic field (B₀ field) whose direction at the same time defines an axis (normally the z-axis) of the co-ordinate system on which the measurement is based. The magnetic field produces different energy levels for the individual nuclear spins in dependence on the magnetic field strength which can be excited (spin resonance) by application of an electromagnetic alternating field (RF field, also referred to as B₁ field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) while the magnetic field extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant T₁ (spin lattice or longitudinal relaxation time), and the magnetization in the direction perpendicular to the z direction relaxes with a second time constant T₂ (spin-spin or transverse relaxation time). The variation of the magnetization can be detected by means of one or more receiving RF coils which are arranged and oriented within an examination volume of the MR device in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing pulse (for example a 180° pulse). This produces an echo signal (spin echo) in the receiving coils.

In order to realize spatial resolution in the body, switched linear magnetic field gradients extending along the three main axes are superposed on the uniform magnetic field, leading to a linear spatial dependency of the spin resonance frequency. The signal picked up in the receiving coils then contains components of different frequencies which can be associated with different locations in the body. The MR signal data obtained via the RF coils corresponds to the spatial frequency domain and is called k-space data. The k-space data usually includes multiple lines acquired with different phase encoding. Each line is digitized by collecting a number of samples. A set of k-space data is converted to a MR image by means of Fourier transformation.

Perfusion refers to the delivery of oxygen and nutrients to tissues of a patient by means of blood flow and is one of the most fundamental physiological parameters. Disorders of perfusion account for a number of the leading causes of medical disability and mortality. Several MR imaging methods for the measurement of tissue perfusion are known in the art. For example diffusible tracers that can be monitored with MR imaging may be applied. Such tracers include, for example, fluorinated halocarbons, deuterated water, ¹⁷O-water, and ¹³C labeled hydrocarbons. However, magnetically labeled endogenous blood water can also be used as a tracer for perfusion MR imaging. To accomplish this, the longitudinal magnetization of arterial blood water can be manipulated so that it differs from the tissue magnetization. Such methods are usually referred to as arterial spin labeled (ASL) perfusion MR imaging (see for example US 6,564,080 B1).

### SUMMARY OF THE INVENTION

In ASL imaging spatially selective inversion or saturation of water protons in inflowing arterial blood are used to label the blood flow. The MR signal amplitude emanating from the labeled blood is reduced or made negative relative to the unlabeled blood. When the labeled blood reaches the tissue within the imaging region, it attenuates the MR signal emanating from the perfused tissue. Voxel-by-voxel subtraction of a labeled image from a control (i.e. unlabeled) image yields a measure of the amount of labeled blood which flowed into the imaged tissue. This quantity is closely related to the tissue perfusion. The difference in the MR signal intensity for labeled and control images is typically a few percent of the tissue MR signal and, therefore, ASL difference MR images are often suffering from the influence of image noise. Typically, many repetitions (10-50) of the ASL acquisitions are averaged to increase the signal-to-noise ratio (SNR). This requirement extends the acquisition time of a perfusion MR image to several minutes making the whole technique prone to motion corruption. The ASL technique is sensitive to patient motion with respect to the imaging region. Patient motion becomes even more a problem in ASL acquisitions when the aim is to measure the perfusion through an individual feeding artery. In this case, the spatially selective preparation sequence used for labeling of the blood water protons excites nuclear magnetization in a volume which is restricted so as to label only the blood in a single vessel. Hence, patient motion not only affects the imaging region but can also cause the targeted vessel to move in and out of the labeling focus resulting in a reduced or even no usable image contrast. Hence, the quality of an ASL MR image will generally be degraded when motion occurs a) during the labeling phase, b) during the MR signal acquisition phase, and c) during both the labeling and the signal acquisition phase.

From the foregoing it is readily appreciated that there is a need for an improved MR imaging method. It is consequently an object of the invention to enable MR imaging using arterial spin labeling with reliable motion detection and motion compensation. In accordance with the invention, a method of MR imaging of at least a portion of a body placed in a main magnetic field within the examination volume of a MR device is disclosed. The method comprises the following steps:
- subjecting the portion of the body to a spatially selective preparation sequence comprising one or more RF pulses and switched magnetic field gradients, which preparation sequence excites nuclear magnetization outside or inside an imaging region;
- subjecting the portion of the body to a spatially selective acquisition sequence comprising one or more RF pulses and switched magnetic field gradients, whereby MR signals are acquired from the imaging region;
- subjecting the portion of the body to a navigator sequence comprising one or more RF pulses and switched magnetic field gradients, which navigator sequence is applied at least once before, during or after the preparation sequence and/or before, during or after the acquisition sequence, whereby navigator signals are acquired from the portion of the body;

- deriving translation and/or rotation data from the navigator signals, which translation and/or rotation data reflect motion of the body;
- reconstructing a MR image from the acquired MR signals,
   wherein the translation and/or rotation data are used for adapting the preparation sequence and/or the imaging sequence and/or for motion correction during reconstruction of the MR image.

As in conventional ASL MR imaging, the portion of the body is initially subjected to a preparation sequence for labeling the blood by exciting the blood water protons outside or inside the actual imaging region. Subsequently, the portion of the body is subjected to a spatially selective acquisition sequence for acquiring MR signals from the imaging region, wherein the inflow of the blood labeled by means of the preparation sequence into the image region alters the image contrast of the MR image finally reconstructed from the acquired MR signals.

According to the invention, the portion of the body is additionally subjected to a navigator sequence which can be applied before, during or after the preparation sequence. It is also possible to apply the navigator sequence - alternatively or additionally - before, during or after the acquisition sequence. Translation and/or rotation data are derived from the navigator signals acquired by means of the navigator sequence. The translation and/or rotation data reflect motion of the patient's body and are used in accordance with the invention for adapting the preparation sequence and/or the imaging sequence. The translation and/or rotation data can further be used in a post-processing step for motion correction, i.e. during reconstruction of the MR image.

It is the gist of the invention to employ per se known MR navigator techniques to improve MR ASL imaging with respect to its sensitivity to motion. The invention enables monitoring both the position of a targeted vessel in the labeling phase, i.e. while the portion of the body is subjected to the preparation sequence, and the position and/or orientation of the anatomical feature of interest (for example the patient's head) during the MR signal acquisition phase, i.e. while the portion of the body is subjected to the acquisition sequence. In each case, the obtained translation or rotation data can be used either to prospectively adapt the preparation sequence and/or the imaging sequence. Furthermore, the translation and/or rotation data can be used during post-processing, for example to apply appropriate geometric corrections to the acquired MR signal data or to decide to exclude some of the MR signal data from MR image reconstruction, in case the respective MR signal data has been acquired during particularly strong patient motion. Moreover, a general motion model may be used for retrospective correction of the acquired MR signals in order to reduce motion-induced blurring or distortion in the reconstructed MR image.

A navigator sequence within the meaning of the invention is generally a scanning sequence which can be used for determining and acquiring translation and/or rotation data. By means of the navigator sequence, which is per se known in the art, typically low-resolution data of a one-, two- or three-dimensional volume is acquired for measuring a translation of an anatomical feature along at least one coordinate axis and/or a rotation of the anatomical feature about at least one coordinate axis. The translation and/or rotation data is used, as mentioned before, either for adapting the preparation sequence and/or the imaging sequence. This means that, for example, the labeling focus of the preparation sequence is altered in synchronism with the detected patient motion in order to keep the labeling focus on the selected blood vessel. Moreover, the translation and/or rotation data may be used to adapt the position and/or rotation of the stack of image slices or any other two- or three-dimensional imaging volume according to the detected patient motion. In this way, the position of the imaged volume can be kept fixed relative to the moving patient anatomy. Adapting the preparation and/or imaging sequence include adaptations in the switched magnetic field gradients to compensate for affine motion.

According to a preferred embodiment of the invention, the MR signals are acquired after precedent excitation of nuclear magnetization outside or inside the imaging region in a labeling mode, wherein further MR signals are acquired without precedent excitation of nuclear magnetization outside the imaging region in a control mode. This corresponds to the conventional ASL approach, in which, as mentioned above, the subtraction of a MR image acquired in labeling mode from a MR image acquired in control mode yields a measure of tissue perfusion in the imaging region.

In another preferred embodiment of the invention, the RF pulses and the switched magnetic field gradients of the preparation sequence are controlled so as to excite (i.e. invert or saturate) the nuclear magnetization of blood water protons within an upstream region, wherefrom the blood is flowing into the imaging region. This also coincides with the conventional ASL approach, in which the blood is selectively labeled in an upstream region, from where the labeled blood flows into the imaging region. MR signals are acquired after a delay time from the imaging region, at an instant at which the labeled blood has reached the imaging region.

Due to the intrinsically low SNR of the ASL technique, the application of the navigator sequence according to the invention, as well as the application of the preparation sequence and the acquisition sequence should be repeated a plurality of times (typically 10-50 times), wherein an average MR image is reconstructed from the acquired MR signals. The averaged MR image may be reconstructed by weighted superposition of the MR signals acquired during each repetition step, wherein the weighting factors may be derived in a preferred embodiment of the invention from the navigator signals. MR signals acquired during significant patient motion are associated with a small weighting factor, such that motion artifacts in the finally reconstructed MR image are reduced.

The method of the invention described thus far can be carried out by means of a MR device including at least one main magnet coil for generating a main magnetic field within an examination volume, a number of gradient coils for generating switched magnetic field gradients in different spatial directions within the examination volume, at least one RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention is preferably implemented by a corresponding programming of the reconstruction unit and/or the control unit of the MR device.

The method of the invention can be advantageously carried out in most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows a MR device for carrying out the method of the invention;
Fig. 2 shows ASL MR images of the brain acquired and reconstructed according to the invention;
Fig. 3 shows time diagrams illustrating different embodiments of the invention.

### DETAILED DESCRIPTION OF EMBODIMENTS

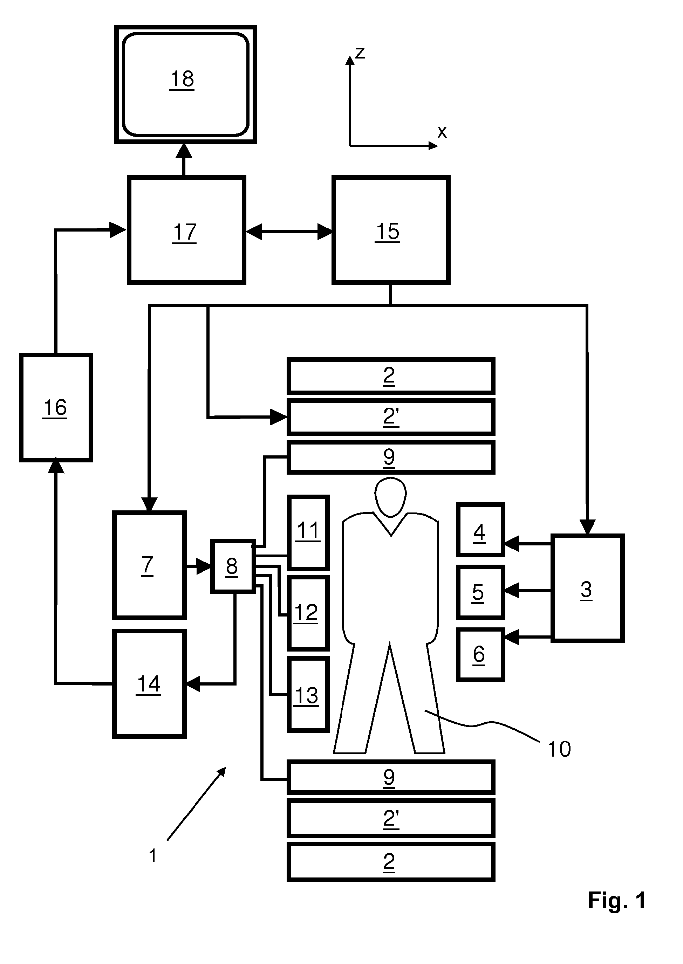

With reference to Figure 1, a MR device 1 is shown. The device comprises superconducting or resistive main magnet coils 2 such that a substantially uniform, temporally constant main magnetic field B₀ is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

Most specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a body RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the current flow through the shimming coils 2' as well as the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modem MR devices the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms, such like SENSE or SMASH. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

In accordance with the invention, ASL perfusion imaging is applied, for example in order to examine the blood perfusion in the patient's brain. The ASL technique is applied in accordance with the invention in combination with a navigator technique for detecting patient motion and for adapting the preparation and/or imaging sequence accordingly. Moreover, motion correction can be performed during image reconstruction on the basis of the detected patient motion.

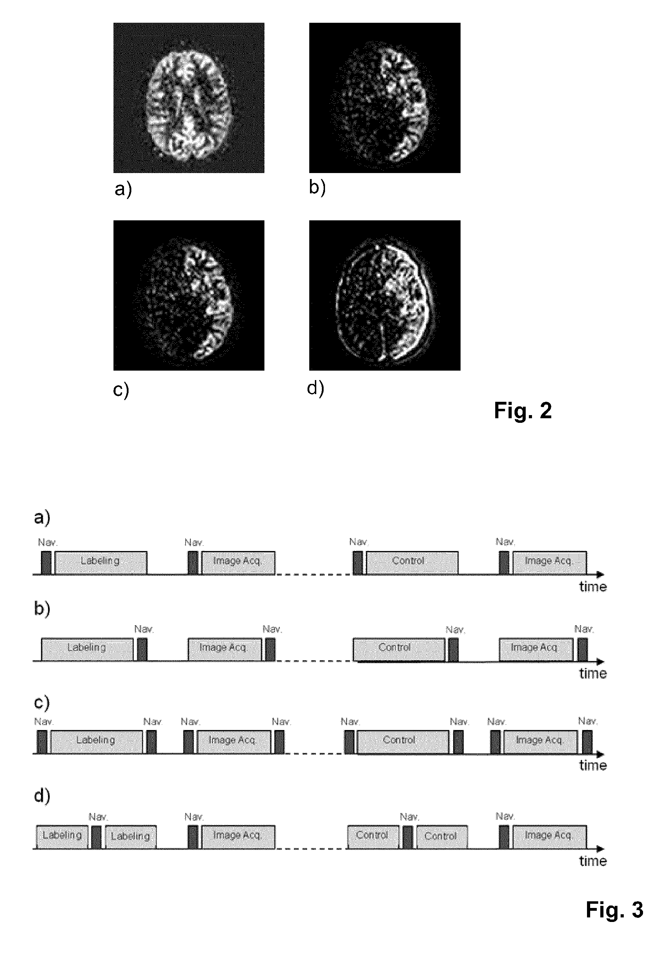

Figure 2a shows a perfusion-weighted brain image acquired with the ASL technique according to the invention. In Figure 2a the blood in all arteries in the neck has been labeled by means of a preparation sequence resulting in a whole brain perfusion-weighted image. In Figure 2b only the blood in the left internal carotid artery has been selectively labeled resulting in a perfusion-weighted MR image showing only the vessel-associated perfusion territory. Figures 2c and 2d show the effect of motion-compensation on the basis of navigators according to the invention. Figure 2c shows a perfusion-weighted MR image acquired with ASL with motion-compensation according to the invention. In Figure 2d, translational motion of the head occurred between successively acquired MR images in labeling mode and in control mode respectively. The patient motion, which has not been compensated for, significantly compromises the image quality of the reconstructed MR image.

A standard ASL imaging protocol may be used in accordance with the invention. As shown in Figure 3, such an ASL protocol consists of two sequences: a preparation sequence (designated by "Labeling" or "Control", respectively, in Figure 3) and an acquisition sequence (designated by "Image Acq." in Figure 3). The preparation sequence can include any non-selective or selective technique for the labeling of the blood. The acquisition sequence includes an appropriate read-out technique for acquisition of MR signals, for example, echo-planar imaging (EPI) or balanced steady-state free precession. Additional pre-saturation and background suppression techniques may be employed to suppress MR signals from static tissue within the imaging region.

In the embodiment shown in Figure 3a, a navigator sequence (designated by "Nav." in Figure 3) is applied before the preparation sequence. In this way the position and/or orientation of a targeted artery is prospectively measured each time before the blood labeling is performed. In this way sufficient labeling of the blood is ensured even in the case of relevant patient motion. The translation and/or rotation data derived from the navigator signals are used to update the artery position in the labeling process and to adapt the labeling focus of the preparation sequence to the actual vessel geometry. In the same way, a second navigator sequence (which may be of a different kind than the navigator sequence applied before the preparation sequence) is applied before the acquisition sequence. In this way, the position of the head of the patient is prospectively measured. The translation and/or rotation data derived from the navigator signals acquired before the acquisition sequence are used to adapt the slice acquisition process in real-time and to change the geometry of the imaging stack. In this way it is made sure that the same anatomy is scanned in each repetition.

In order to ensure sufficient labeling of the blood, the navigator sequence is employed in the embodiment shown in Figure 3b after the application of the preparation sequence. The navigator sequence measures the position of the target artery each time after the blood labeling is performed. The obtained translation and/or rotation data are used to check whether the labeling focus has been centered correctly on the selected vessel. On this basis a decision can be made whether the acquisition sequence should be performed or not. In case the labeling focus needs to be repositioned, the acquisition sequence can be omitted and blood labeling can be performed again with appropriately adapted parameters. In the same way, a second navigator sequence is applied after the acquisition sequence to retrospectively measure the position of the patient's anatomy. The translation and/or rotation data are used for adapting subsequent acquisition sequences. The retrospectively acquired navigator signals can also be used to control the MR image reconstruction process. The acquired MR signal data can be weighted accordingly. It is also possible to completely exclude the actually acquired MR signal data from the further analysis, in case a too strong patient motion has been detected.

In the embodiment shown in Figure 3c, two navigator sequences are employed both before and after the labeling process. In this way the position of the targeted artery is prospectively and retrospectively measured in order to ensure sufficient labeling of the blood. In the same way, navigator sequences are applied before and after the acquisition sequence, thereby prospectively and retrospectively measuring the position of the head, similar to the embodiments shown in Figures 3a and 3b.

In the embodiment shown in Figure 3d, the navigator sequence is applied within the preparation sequence. The navigator sequence intercepts the labeling process to measure the position of the targeted artery each time the labeling is performed.

In a further embodiment, which is not shown in the Figures, a combined preparation and navigator sequence may be employed, in which the acquisition of the navigator signals is integrated into the RF pulse train used for blood labeling. In a similar manner, a navigator sequence may be integrated into the acquisition sequence. In this way, patient motion is monitored simultaneously with the labeling process and also simultaneously with the MR signal acquisition.

The approach of the invention is particularly well-suited for non-selective and selective MR perfusion examinations of the brain based on the ASL technique. However, the approach of the invention may also find application for perfusion measurements in other organs, for example in abdominal or cardiac MR imaging.

## Claims

1. Method of MR imaging of at least a portion of a body (10) placed in a main magnetic field within the examination volume of a MR device (1), the method comprising the following steps:
- subjecting the portion of the body (10) to a spatially selective preparation sequence comprising one or more RF pulses and switched magnetic field gradients, which preparation sequence excites nuclear magnetization outside or inside an imaging region;
- subjecting the portion of the body (10) to a spatially selective acquisition sequence comprising one or more RF pulses and switched magnetic field gradients, whereby MR signals are acquired from the imaging region;
- subjecting the portion of the body (10) to a navigator sequence comprising one or more RF pulses and switched magnetic field gradients, which navigator sequence is applied at least once before, during or after the preparation sequence and/or before, during or after the acquisition sequence, whereby navigator signals are acquired from the portion of the body (10);
- deriving translation and/or rotation data from the navigator signals, which translation and/or rotation data reflect motion of the body (10);
- reconstructing a MR image from the acquired MR signals,
wherein the translation and/or rotation data are used for adapting the preparation sequence and/or the imaging sequence and/or for motion correction during reconstruction of the MR image.

2. Method of claim 1, wherein MR signals are acquired after precedent excitation of nuclear magnetization outside or inside the imaging region in a labeling mode, and wherein MR signals are acquired without precedent excitation of nuclear magnetization outside or inside the imaging region in a control mode.

3. Method of any one of claim 1 or 2, wherein a motion model is used for correcting motion during reconstruction of the MR image.

4. Method of any one of claim 1-3, wherein the RF pulses and the switched magnetic field gradients of the preparation sequence are controlled so as to excite nuclear magnetization of blood within an upstream region, wherefrom the blood is flowing into the imaging region.

5. Method of any one of claims 1-4, wherein the position and/or orientation of a blood vessel is derived from the navigator signals, wherein the RF pulses and the switched magnetic field gradients of the preparation sequence are controlled so as to excite nuclear magnetization of blood within the blood vessel.

6. Method of any one of claims 1-5, wherein the position and/or orientation of a part of the body (10) is derived from the navigator signals, wherein the RF pulses and the switched magnetic field gradients of the acquisition sequence are controlled so as to adapt the position and/or orientation of the imaging region corresponding to the position and/or orientation of the part of the body (10).

7. Method of any one of claims 1-6, wherein the application of the navigator sequence, the preparation sequence and the acquisition sequence are repeated a plurality of times, wherein an averaged MR image is reconstructed from the acquired MR signals.

8. Method of claim 7, wherein the averaged MR image is reconstructed by weighted superposition of MR signals acquired during each repetition, the weighting factors being derived from the navigator signals.

9. MR device comprising at least one main magnet coil (2) for generating a main magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from a body (10) of a patient positioned in the examination volume, a control unit (15) for controlling the temporal succession of RF pulses and switched magnetic field gradients, and a reconstruction unit (17) for reconstructing MR images from the received MR signals, wherein the MR device (1) is arranged to perform the following steps:
- subjecting the portion of the body (10) to a spatially selective preparation sequence comprising one or more RF pulses and switched magnetic field gradients, which preparation sequence excites nuclear magnetization outside or inside an imaging region;
- subjecting the portion of the body (10) to a spatially selective acquisition sequence comprising one or more RF pulses and switched magnetic field gradients, whereby MR signals are acquired from the imaging region;
- subjecting the portion of the body (10) to a navigator sequence comprising one or more RF pulses and switched magnetic field gradients, which navigator sequence is applied at least once before, during or after the preparation sequence and/or before, during or after the acquisition sequence, whereby navigator signals are acquired from the portion of the body (10);
- deriving translation and/or rotation data from the navigator signals, which translation and/or rotation data reflect motion of the body (10);
- reconstructing a MR image from the acquired MR signals,
wherein the translation and/or rotation data are used for adapting the preparation sequence and/or the imaging sequence and/or for motion correction during reconstruction of the MR image.

10. Computer program to be run on a MR device (1), which computer program comprises instructions for:
- generating a spatially selective preparation sequence comprising one or more RF pulses and switched magnetic field gradients, which preparation sequence excites nuclear magnetization outside or inside an imaging region;
- generating a spatially selective acquisition sequence comprising one or more RF pulses and switched magnetic field gradients, whereby MR signals are acquired from the imaging region;
- generating a navigator sequence comprising one or more RF pulses and switched magnetic field gradients, which navigator sequence is applied at least once before, during or after the preparation sequence and/or before, during or after the acquisition sequence, whereby navigator signals are acquired from the portion of the body (10);
- deriving translation and/or rotation data from the navigator signals, which translation and/or rotation data reflect motion of the body (10);
- reconstructing a MR image from the acquired MR signals,
wherein the translation and/or rotation data are used for adapting the preparation sequence and/or the imaging sequence and/or for motion correction during reconstruction of the MR image.
